# EUROPEAN PATENT APPLICATION

(11) **EP 1 763 080 A2**
(43) Date of publication of application: **14.03.2007**
(21) Application number: 06120354.3
(22) Date of filing: 08.09.2006
(51) Int. Cl.: H01L 27/115, H01L 21/8247

(54) **Non-volatile memory device**

(30) Priority: 08.09.2005 US 714852 P
(71) Applicant: Saifun Semiconductors Ltd., Netanya 42505 (IL)
(72) Inventor: Lusky, Eli, Tel-Aviv (IL); Eitan, Boaz, 43259, Ra'anana (IL)
(74) Representative: Andersson, Björn E.

(57) **Abstract**

A non-volatile memory device includes a plurality of word line areas each separated from its neighbor by a contact area, an oxide-nitride-oxide (ONO) layer within the word line areas and at least partially within the contact areas and protective elements generated when spacers are formed in the periphery area, to protect silicon under the ONO layer in the contact areas A non-volatile memory device includes a plurality of word line areas each separated from is neighbor by a contact area and bit line oxides whose height is at least a quarter of the distance between neighboring bit line oxides.

## Description

### CROSS-REFERENCE TO RELATED APPLICATIONS

This application claims benefit from U.S. Provisional Patent Application No. 60/714,852, filed September 8, 2005, which is hereby incorporated in its entirety by reference.

### FIELD OF THE INVENTION

The present invention relates to symmetric memory arrays generally and to contact areas therein in particular.

### BACKGROUND OF THE INVENTION

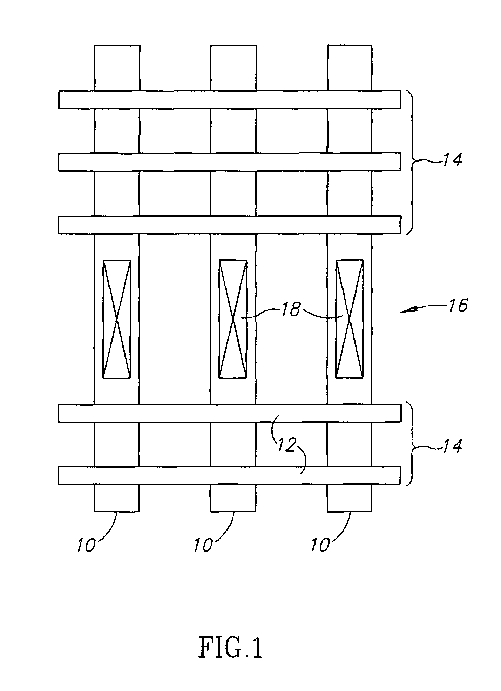

Symmetric memory arrays are known in the art. One type of symmetric memory array, shown in Fig. 1, to which reference is now made, is commonly used for NROM (nitride read only memory) arrays. It has bit lines 10 extending in columns throughout the array and rows of word lines 12 crossing bit lines 10. Word lines 12 are grouped into sections 14, where each section 14 is separated from its neighbor by a contact area 16.

Contacts 18, in contact areas 16, bring power to bit lines 10, typically by connecting between metal lines (not shown) and bit lines 10. Contacts 18 typically are large and thus, cannot fit within the standard spacing of word lines 12. In one type of array, each contact area 16 occupies the space of one word line 12 and the spacing to both of its neighboring word lines.

The following patents and patent applications describe a dual polysilicon process (DPP) for the NROM cell: US 2004/0157393 to Hwang describes a manufacturing process for a non-volatile memory cell of the SONOS type which attempts to reduce or minimize the undesirable effects of small dimension components. US 6,686,242 B2 to Willer et al. describes an NROM cell that they claim can be implemented within a 4F² area. US Serial Number 11/247,733, assigned to the common assignees of the present invention, describes a further process for manufacturing NROM cells.

In the DPP process, a first polysilicon layer is deposited in columns between which bit lines 10 are implanted. Bit line oxides (not shown) are deposited in the spaces between first polysilicon columns and may be formed as blocked columns covering bit lines 10. Word lines 12 may then be deposited as a second polysilicon layer, cutting the columns of the first polysilicon layer into islands between bit lines 10. For NROM cells, an ONO layer (also not shown) is laid down over the entire array prior to deposition of the polysilicon layers and it may be removed from above bit lines 10.

A common practice for NROM arrays is to silicide the second polysilicon layer in order to reduce the resistance of the word lines. This involves silicidation of the second polysilicon layer after its deposition but prior to patterning of the word lines. Tungsten silicide is typically used for this purpose. The double layer is then cut into the word lines.

Self-Aligned Silicidation, known as "Salicide", is an alternative method for silicidation of word lines. In this process, word lines are first patterned, after which the second polysilicon layer is etched, to generate the word lines, and oxide spacers are then created on the array. After that has been completed, the array is silicided. The silicidation self-aligns to the second polysilicon word lines. Note that, in the word line areas, oxide spacers are not typically generated. Instead, the oxide for the spacers completely fills the gap between word lines. For the Salicide process, Copper or Nickel silicide are typically used.

It is know in industry that, during salicidation of the polysilicon, exposed silicon will be salicided as well. This is a particular problem in the area of the bit line contacts. If the bit line area is not protected, with an STI (Silicon Trench Isolation) or another dielectric layer, salicidation of this layer will create a leakage path.

NROM cells are described in many patents, for example in U.S. 6,649,972, assigned to the common assignees of the present invention, whose disclosure is incorporated herein. Where applicable, descriptions involving NROM are intended specifically to include related oxide-nitride technologies, including SONOS (Silicon-Oxide-Nitride-Oxide-Silicon), MNOS (Metal-Nitride-Oxide-Silicon), MONOS (Metal-Oxide-Nitride-Oxide-Silicon) and the like used for NVM devices. Further description of NROM and related technologies may be found at "Non Volatile Memory Technology", 2005 published by Saifun Semiconductor and materials presented at and through http://siliconnexus.com, "Design Considerations in Scaled SONOS Nonvolatile Memory Devices" found at:

http://klabs.org/richcontent/MemoryContent/nvmt_symp/nvmts_2000/presentations/b u_white_sonos_lehigh_univ.pdf,

"SONOS Nonvolatile Semiconductor Memories for Space and Military Applications" found at:

http://klabs.org/richeontent/MemoryContent/nvmt_symp/nvmts_2000/papers/adams_ d.pdf,

"Philips Research - Technologies - Embedded Nonvolatile Memories" found at:

http://research.philips.com/technologies/ics/nvmemories/index.html, and

"Semiconductor Memory: Non-Volatile Memory (NVM)" found at:

http://ece.nus.edu.sg/stfpage/elezhucx/myweb/NVM.pdf, all of which are incorporated by reference herein in their entirety.

### SUMMARY OF THE PRESENT INVENTION

There is provided, in accordance with a preferred embodiment of the present invention, a non-volatile memory device includes a plurality of word line areas each separated from its neighbor by a contact area, an oxide-nitride-oxide (ONO) layer within the word line areas and at least partially within the contact areas and protective elements, generated when spacers are formed in the periphery area, to protect silicon under the ONO layer in the contact areas.

Moreover, in accordance with a preferred embodiment of the present invention, the protective elements are formed of one of the following: oxide, nitride and oxide-nitride-oxide.

Further, in accordance with a preferred embodiment of the present invention, the spacers are formed of liners of 50 - 150nm thick.

Still further, in accordance with a preferred embodiment of the present invention, the word line areas include either Salicided or silicided word lines. The Salicided word lines may be Salicided with Copper or Nickel silicide and the silicided word lines may be silicided with Tungsten silicide.

There is also provided, in accordance with a preferred embodiment of the present invention, a non-volatile memory device including a plurality of word line areas each separated from its neighbor by a contact area and bit line oxides whose height is at least a quarter of the distance between neighboring bit line oxides.

Additionally, in accordance with a preferred embodiment of the present invention, the device also includes protective elements at least between the bit line oxides in the contact area.

Still further, in accordance with a preferred embodiment of the present invention, the word line areas include either Salicided or silicided word lines. The Salicided word lines may be Salicided with Copper or Nickel silicide and the silicided word lines may be silicided with Tungsten silicide.

### BRIEF DESCRIPTION OF THE DRAWINGS

The subject matter regarded as the invention is particularly pointed out and distinctly claimed in the concluding portion of the specification. The invention, however, both as to organization and method of operation, together with objects, features, and advantages thereof, may best be understood by reference to the following detailed description when read with the accompanying drawings in which:

Fig. 1 is schematic illustration of a prior art memory array;

Figs. 2A and 2B are isometric illustrations of a prior art contact area of the memory array of Fig. 1 in an ideal state and an over etched state, respectively;

Figs. 3A and 3B are cross-sectional illustrations of a CMOS area of a prior art memory array after deposition of a liner and its etchback, respectively; and

Figs. 4A and 4B are cross-sectional illustrations of a contact area of the memory array of the present invention after deposition of a liner and its etchback, respectively.

It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

### DETAILED DESCRIPTION OF THE PRESENT INVENTION

In the following detailed description, numerous specific details are set forth in order to provide a thorough understanding of the invention. However, it will be understood by those skilled in the art that the present invention may be practiced without these specific details. In other instances, well-known methods, procedures, and components have not been described in detail so as not to obscure the present invention.

Applicants have realized that the Salicide process has drawbacks in the contact areas of a symmetric memory array.

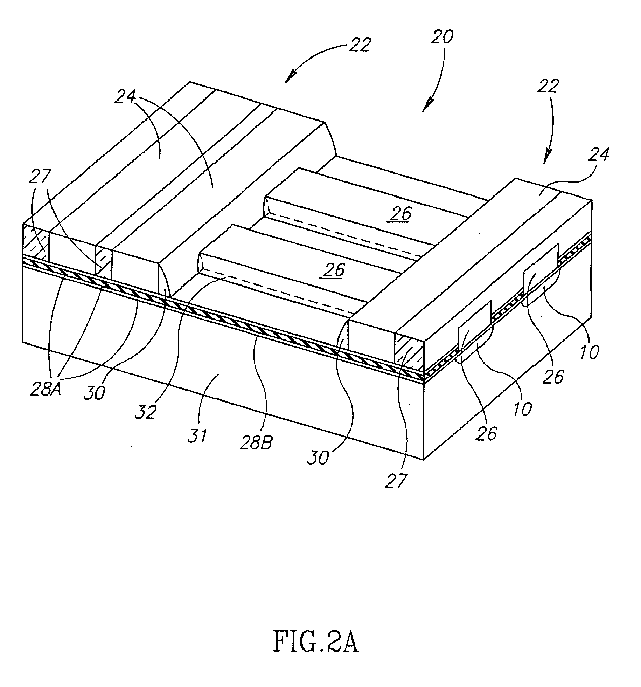

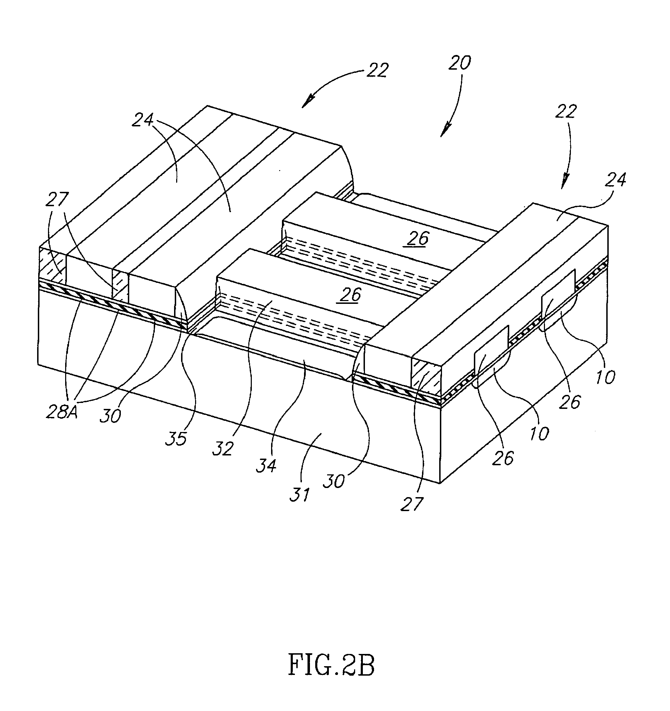

Reference is now made to Figs. 2A and 2B, which are isometric illustrations of a dual polysilicon process (DPP) memory array before generation of the contacts. Figs. 2 show a contact area, here labeled 20, and its neighboring word line areas 22. Three word lines 24 can be seen, lying perpendicular to and over bit line oxides 26. Between word lines 24 is oxide fill 27, generated during the oxide spacer process. Fig. 2A shows oxide spacers 30 and 32, also generated during the oxide spacer process, where first oxide spacers 30 are formed at the edges of contact region 20 and second oxide spacers 32 are formed within contact region 20, on the sides of bit line oxides 26. In the spaces between bit line oxides 26 are oxide-nitride-oxide (ONO) layers 28. ONO layers 28 and bit line oxides 26 are not visible in word line sections 22 as they are covered either by word lines 24 or by oxide fill 27 (although ONO layer 28 is visible in the cross-section at the side of Fig. 2A).

Applicants have realized that the Salicide process may cause serious damage in contact areas 20 because the etching of one or both of the spacers and the word lines (1^{st} and 2^{nd} polysilicon layers) may over etch ONO layer 28B. The word line etch may remove the top oxide of the ONO layer 28 while the spacer etch may remove at least the nitride layer if not also the* some or all of the bottom oxide.

If ONO layer 28B is damaged, then the silicon, labeled 31, underneath ONO layer 28B (Fig. 2A) in contact region 20 may be revealed. Fig. 2B shows ONO 28B etched down to the bottom oxide layer, at a location labeled 34, and silicon 31 revealed in ditches 35 at the edges of oxide spacers 30 and 32. As a consequence, during the following Salicide process, silicon 31 may become silicided. The silicided silicon 31 may form a conductive path between adjacent bit lines 10 (which are covered by bit line oxides 26 in Figs. 2A and 2B) which may cause electrical shorts between neighboring bit lines 10.

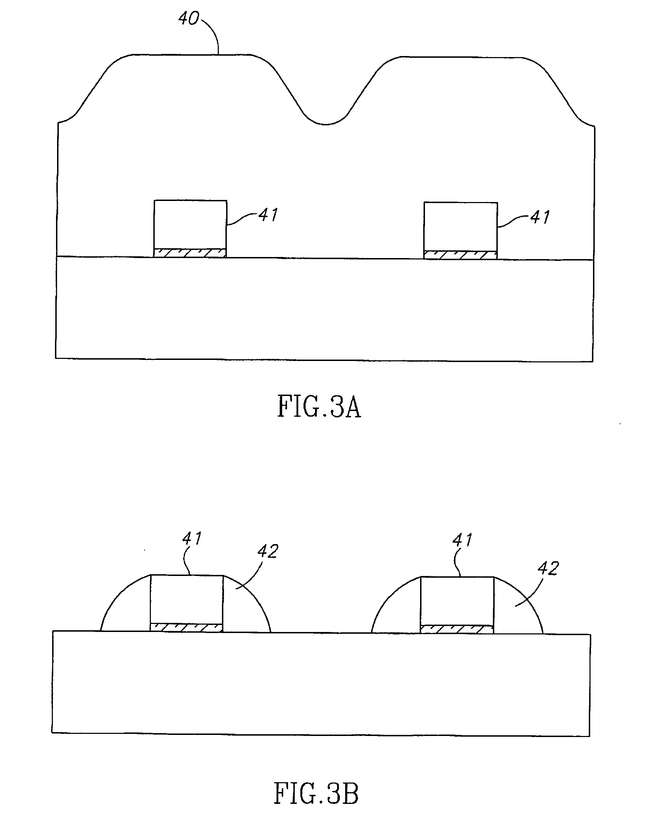

Applicants have realized that the step which produces spacers 30 and 32 is the same step which generates spacers in the complementary metal oxide semiconductor (CMOS) periphery (not shown) of the memory array. Figs. 3A and 3B, to which reference is now made, show the generation of CMOS spacers 42 in the periphery of the memory array. Fig. 3A shows two, widely spaced polysilicon gates 41, since polysilicon lines are far apart in the periphery. CMOS spacers 42 are typically created by first depositing a liner 40, which may be oxide, nitride or ONO, and is significantly thick, typically on the order of the thickness of bit line oxides 26 or thicker. For example, liner 40 may be 50 - 150nm thick. Liner 40 is then etched back anisotropically, in which the flat surfaces etch significantly faster than the non-flat surfaces, resulting in a wedge-shaped spacer 42 (Fig. 3B). Because liner 40 is thick, spacers 42 are wide.

The etch back is designed to stop once the liner 40 is removed from on top of polysilicon gates 41. Since word lines 24 (Figs. 2A and 2B) of the array are close together in word line area 22, the etchback between neighboring word lines does not reach down to ONO layers 28A between word lines 24 before the etching is stopped. In fact, as shown in Figs. 2A and 2B, the etchback leaves fill 27, shown as an oxide fill, between word lines 24. However, in contact area 20, there are no word lines and, in the prior art as shown in Fig. 2B, the etchback continued down to the ONO layers 28B. Thus, layer 28B is not shown in Fig. 2B. Instead, only its bottom oxide layer 34 is shown and spacers 30 and 32 are shown extending even to silicon 31.

It will be appreciated that liner 40 covers the chip, which includes both the periphery and the memory array. As can be seen in Fig. 3A, which shows a portion of the CMOS periphery, liner 40 lays flat over flat elements, such as word lines 41, and has dips 43 between elements. The closer the elements are to each other, the smaller the dips. Applicants have realized that, if contact area 20 shown in Figs 2A and 2B has elements with enough height, liner 40 will have very shallow dips in it. Such dips, when etched back, will not be deep enough to etch down to ONO layer 28 and hence, little or no spacer will be formed in contact area 20. This may protect silicon 31 from damage during the etchback.

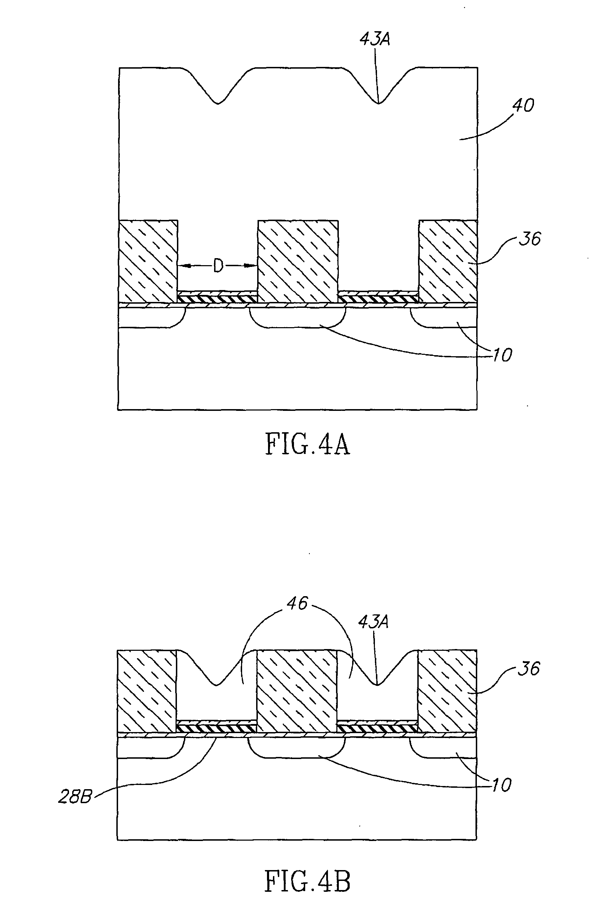

Applicants have realized that raising the height of bit line oxides 26 may provide the tall elements. This is shown in Figs. 4A and 4B, to which reference is now made. In this embodiment, the bit line oxides, here labeled 36, may be taller than bit line oxides 26 of the prior art. Fig. 4A shows bit line oxides 36, such as in contact area 20 of Figs 2A and 2B, after the deposition of liner 40. There are dips 43A in liner 40.

In the prior art, bit line oxides 26 (Figs 2A and 2B) were defined as a function of the voltage that the oxides could handle and were typically 30 - 50nm. Taller bit line oxides 36 may additionally be defined by the distance D (Fig. 4A) between bit lines 10 and by the liner thickness. For example, the height of bit line oxides 36 (Figs. 4A and 4B) may additionally be defined as a portion, such as ¼ - 1, of the distance D between bit lines 10. For example, for a distance D between bit lines 10 of 120nm, bit lines 36 may be ½ D, or 60nm tall.

Fig. 4B shows bit line oxides 36 in contact area 20 after the CMOS spacer etch step, which takes place simultaneously over the array and over the periphery areas. Since dips 43A are relatively small and are etched slower than the flat surfaces of liner 40, dips 43A change little or expand slightly during the etch. As long as dips 43A began with a depth smaller than the height of bit line oxides 36, the spacer etch step will not etch them down to ONO layer 28B, leaving a layer of protection 46 over ONO layer 28B.

Typically, the liner thickness is determined by the standard processes of the* CMOS periphery. In the present invention, the ratio of the height of bit line oxides 36 to the distance D between bit lines depends on the liner thickness and on any process steps that may partially partial etch of bit line oxides 36.

It will be appreciated that the process described hereinabove is not limited to implementation with the Salicide process. Protecting silicon 31 in the contact area is important irrespective of the cause of the damage. Thus, increasing the height of the bit lines may be useful for word lines silicided by the standard silicide process and/or as a general protection for the silicon 31 in contact areas 20.

While certain features of the invention have been illustrated and described herein, many modifications, substitutions, changes, and equivalents will now occur to those of ordinary skill in the art. It is, therefore, to be understood that the appended claims are intended to cover all such modifications and changes as fall within the true spirit of the invention.

## Claims

1. A non-volatile memory device comprising:
a plurality of word line areas each separated from its neighbor by a contact area;
an oxide-nitride-oxide (ONO) layer within said word line areas and at least partially within said contact areas; and
protective elements, generated when spacers are formed in the periphery area, to protect silicon under said ONO layer in said contact areas.

2. The device according to claim 1 and wherein said protective elements are formed of one of the following: oxide, nitride and oxide-nitride-oxide.

3. The device according to claim 1 and wherein said spacers are formed of liners of 50 - 150nm thick.

4. The device according to claim 1 and wherein said word line areas comprise Salicided word lines.

5. The device according to claim 1 and wherein said word line areas comprise silicided word lines.

6. The device according to claim 4 and wherein said word lines are Salicided with Copper silicide.

7. The device according to claim 4 and wherein said word lines are Salicided with Nickel silicide.

8. The device according to claim 5 and wherein said word lines are silicided with Tungsten silicide.

9. A non-volatile memory device comprising:
a plurality of word line areas each separated from its neighbor by a contact area; and
bit line oxides whose height is at least a quarter of the distance between neighboring bit line oxides.

10. The device according to claim 9 and also comprising protective elements at least between said bit line oxides in said contact area.

11. The device according to claim 10 and wherein said protective elements are formed of one of the following: oxide, nitride and oxide-nitride-oxide.

12. The device according to claim 11 and wherein said word line areas comprise Salicided word lines.

13. The device according to claim 11 and wherein said word line areas comprise silicided word lines.

14. The device according to claim 12 and wherein said word lines are Salicided with Copper silicide.

15. The device according to claim 12 and wherein said word lines are Salicided with Nickel silicide.

16. The device according to claim 11 and wherein said word lines are silicided with Tungsten silicide.
